# EUROPEAN PATENT APPLICATION

(11) **EP 4 517 843 A1**
(43) Date of publication of application: **05.03.2025**
(21) Application number: 23795539.8
(22) Date of filing: 27.04.2023
(51) Int. Cl.: H01L 31/18, H01L 31/068, C30B 33/10

(54) **SOLAR CELL, PREPARATION METHOD THEREFOR, AND APPLICATION THEREOF**

(30) Priority: 29.04.2022 CN 202210468147
(71) Applicant: Tongwei Solar (Meishan) Co., Ltd., Meishan, Sichuan 620041 (CN)
(72) Inventor: FAN, Jianbin, Meishan, Sichuan 620041 (CN); MENG, Xiajie, Meishan, Sichuan 620041 (CN); XING, Guoqiang, Meishan, Sichuan 620041 (CN)
(74) Representative: Marks & Clerk LLP
(86) International application number: PCT/CN2023/091139
(87) International publication number: WO 2023/208107

(57) **Abstract**

The present application discloses a solar cell, a preparation method therefor, and an application thereof. The preparation method includes: S10, providing a silicon wafer substrate having a first surface and a second surface opposite to the first surface; S20, forming a silicon-containing film on the first surface of the silicon wafer substrate; S30, patterning the silicon-containing film on the first surface by laser to form a patterned region; S40, placing the silicon wafer substrate having the silicon-containing film and the patterned region into an alkaline solution containing a strong monobasic base to obtain a pre-treated silicon wafer substrate, and placing the pre-treated silicon wafer substrate into a texturing liquid containing a strong monobasic base for texturing treatment, wherein a concentration of the strong monobasic base in the alkaline solution is greater than a concentration of the strong monobasic base in the texturing liquid. **In** the above preparation method, not only the additional layer formed in the laser treatment can be effectively removed, but also the effective texturing and the effective etching in the patterned region can be simultaneously achieved in the subsequent texturing treatment, ensuing the good appearance of the front surface of the cell and the performance of the cell.

## Description

### CROSS-REFERENCE TO RELATED APPLICATIONS

This application claims priority to Chinese patent application No. 202210468147.8, filed on April 29, 2022, entitled "SOLAR CELL, PREPARATION METHOD THEREFOR, AND APPLICATION THEREOF", the content of which is hereby incorporated herein in its entireties by reference.

### TECHNICAL FIELD

The present disclosure relates to the field of batteries, particularly relates to a solar cell, a preparation method therefor, and an application thereof.

### BACKGROUND

The back-contact solar cells can achieve maximum utilization of incident light because there is no block to light due to the absence of grid line electrodes on the front surfaces thereof. This, in combination with the light-trapping structures formed by the pyramid textured surfaces and the anti-reflection films on the front surfaces of the cells, reduces the optical loss of the cells and effectively enhances the short-circuit current density of the cells. Among these cells, the finger-crossed back-contact solar cells (IBCs), due to their unique device structures (where the metal electrodes are located on the back sides of the cells and the positive and negative electrodes are arranged in a finger-crossing pattern) and the elimination of the need to consider the contact resistance at the front surfaces, can further optimize light-trapping and passivation performances on the front surfaces, as well as optimize the metal grid line electrodes on the back sides to reduce the series resistance and thereby increase the fill factor.

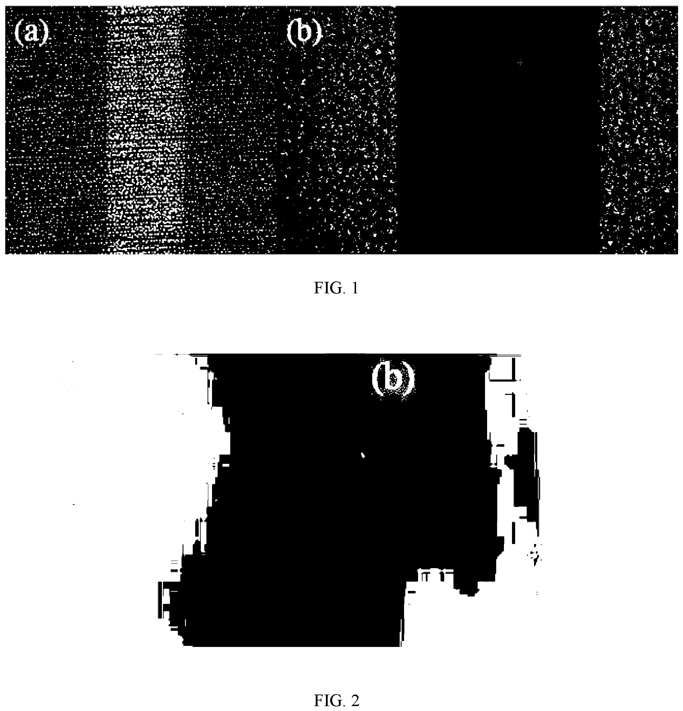

In the traditional process of preparing the back-contact solar cells, a texturing process is often performed after a laser treatment on the back side of the substrate of the cell. During the laser treatment, a thin layer of silicon oxide/silicon/polysilicon mixture is formed on the back side due to the interaction between the laser and the doped region. This layer is difficult to be etched by the texturing liquid within the effective texturing time, meaning that the laser-treated region on the substrate may not be effectively etched, leading to either failure in etching (as shown in FIG. 1(a)) or only localized etching (as shown in FIG. 1(b)). Consequently, it becomes challenging to simultaneously texture the front surface and etch the back side of the cell during the texturing treatment. Furthermore, whether using plasma-enhanced chemical vapor deposition (PECVD), low-pressure chemical vapor deposition (LPCVD), or other methods to prepare the silicon-containing film on the back side, wrapping around the front surface is unavoidable, particularly near the edges of the front surface. This results in localized deposition of the silicon-containing film on the front surface, causing an uneven reaction rate during the texturing process of the front surface, affecting the uniformity of the texturing, and finally leading to poor appearance of the front surface of the cell (as shown in FIG. 2: (a) normal appearance, (b) poor appearance) and a degradation in performance.

### SUMMARY

In view of the above, there is a need to provide a solar cell, a preparation method therefor, and an application thereof to achieve an effect of simultaneously removing the excess layer formed at the silicon-containing film on the substrate during the laser treatment and the silicon-containing film wrapped around the second surface before texturing to ensure the subsequent good texturing effect.

The present disclosure provides a preparation method for a solar cell, including the following steps:
S10: providing a silicon wafer substrate having a first surface and a second surface opposite to the first surface;
S20: forming a silicon-containing film on the first surface of the silicon wafer substrate, the silicon-containing film including a silicon oxide layer, a doped layer, and a mask layer formed sequentially on the first surface of the silicon wafer substrate;
S30: patterning the silicon-containing film on the first surface by laser to form a patterned region;
S40: placing the silicon wafer substrate having the silicon-containing film and the patterned region into an alkaline solution containing a strong monobasic base for pre-treatment, to obtain a pre-treated silicon wafer substrate, and placing the pre-treated silicon wafer substrate into a texturing liquid containing a strong monobasic base for texturing treatment, wherein a concentration of the strong monobasic base in the alkaline solution used in the pre-treatment is greater than a concentration of the strong monobasic base in the texturing liquid used in the texturing treatment.

In an embodiment, the strong monobasic base is selected from a group consisting of potassium hydroxide, sodium hydroxide, and a combination thereof.

In an embodiment, in the step S40, a concentration of the strong monobasic base in the alkaline solution is in a range from 0.3 mol/L to 2 mol/L.

In an embodiment, in the step S40, a time of the treatment with the alkaline solution is in a range from 10 s to 200 s.

In an embodiment, in the step S40, a temperature of the treatment with the alkaline solution is in a range from 60 °C to 80 °C.

In an embodiment, in the step S20, the silicon oxide layer is deposited on the first surface by a method of plasma-enhanced chemical vapor deposition, low-pressure chemical vapor deposition, thermal oxidation, or chain oxidation, and then the doped layer and the mask layer are deposited on the silicon oxide layer by a method of plasma-enhanced chemical vapor deposition or low-pressure chemical vapor deposition.

In an embodiment, the preparation method further includes a step of treating the silicon-containing film wrapped around the second surface of the substrate with a hydrofluoric acid at a concentration of 4 mol/L to 6 mol/L after the step S30 and before the step S40.

In an embodiment, in the step S40, the texturing treatment includes: placing the pre-treated silicon wafer substrate into the texturing liquid containing the strong monobasic base at a concentration of 0.15 mol/L to 0.35 mol/L for the texturing treatment to prepare the silicon wafer substrate with a textured surface.

In an embodiment, after the preparing the silicon wafer substrate with the textured surface, the preparation method further includes: S50, sequentially forming a first passivation film and a first anti-reflection film on the first surface of the silicon wafer substrate having the textured surface.

In an embodiment, after preparing the silicon wafer substrate with the textured surface, the preparation method further includes: S50: sequentially forming a second passivation film and a second anti-reflection film on the second surface of the silicon wafer substrate having the textured surface.

In an embodiment, after the step S50, the preparation method further includes: S60, patterning the patterned region on the first surface with holes by laser, and preparing a first electrode and a second electrode by screen printing.

The present disclosure further provides a solar cell which is prepared by the preparation method for the solar cell as described above.

The present disclosure further provides a photovoltaic system including a solar cell assembly and an auxiliary device. The solar cell assembly includes the solar cell as described above.

In the above-described preparation method for the solar cell, after the formation of the silicon-containing film on the silicon wafer substrate and the laser treatment to the silicon wafer substrate, the silicon wafer substrate having the silicon-containing film and the patterning region is placed into and treated with the alkaline solution containing the strong monobasic base, and then subjected to the texturing treatment, wherein the concentration of the strong monobasic base in the alkaline solution is greater than the concentration of the strong monobasic base in the texturing liquid. Not only the additional layer formed during the laser treatment can be effectively removed by the treatment with the alkaline solution, but also the mask layer, the doped layer, and the silicon oxide wrapped around the front surface can be removed by the treatment with the hydrofluoric acid and the treatment with the alkaline solution, so that in the subsequent texturing treatment, the surface of the substrate can be effectively textured while the patterned region formed after the laser treatment can be effectively etched, ensuring a good appearance of the front surface of the cell and the performance of the cell.

### BRIEF DESCRIPTION OF THE DRAWINGS

In order to illustrate the embodiments of the present disclosure more clearly, the drawings used in the embodiments will be described briefly. It is evident that the following described figures are merely for some embodiments of the present disclosure, and other figures can be derived by those of ordinary skill in the art without any creative effort.
FIG. 1 shows etching effects on back sides of solar cells: (a) failure in etching, and (b) localized etching;
FIG. 2 shows appearances of solar cells: (a) normal appearance, (b) poor appearance;
FIG. 3 shows a flow chart of preparing a solar cell according to the present disclosure;
FIG. 4 shows a top view of a patterned region obtained after patterning a silicon-containing film;
FIG. 5 shows a top view of the patterned region with holes;
FIG. 6 shows a structure of the solar cell according to the present disclosure; and
FIG. 7 shows a top view of the solar cell according to the present disclosure.

### Description of the drawings:

10: solar cell; 110: substrate; 111: patterned region; 120: composite film; 121: silicon oxide layer; 122: doped layer; 123: mask layer; 124: silicon-containing film; 130: first passivation film; 140: second passivation film; 150: first anti-reflection film; 160: second anti-reflection film; 170: first electrode; 180: second electrode.

### DETAILED DESCRIPTION

In order to facilitate an understanding of the present disclosure, the present disclosure will now be described more comprehensively hereinafter with reference to the accompanying drawings. Preferred embodiments of the present disclosure are shown in the drawings. The present disclosure may, however, be embodied in many different forms and is not limited to the embodiments described herein. On the contrary, the purpose of providing these embodiments is to provide a more thorough and comprehensive understanding of the disclosed content of the present disclosure.

Unless otherwise defined, all technical and scientific terms used herein have the same meaning as commonly understood by one of ordinary skill in the art to which the present disclosure belongs. The terminology used herein in the description of the present disclosure is for the purpose of describing particular embodiments only and is not intended to be limiting of the present disclosure. The term "and/or" used herein includes any or all combinations of one or more related listed items.

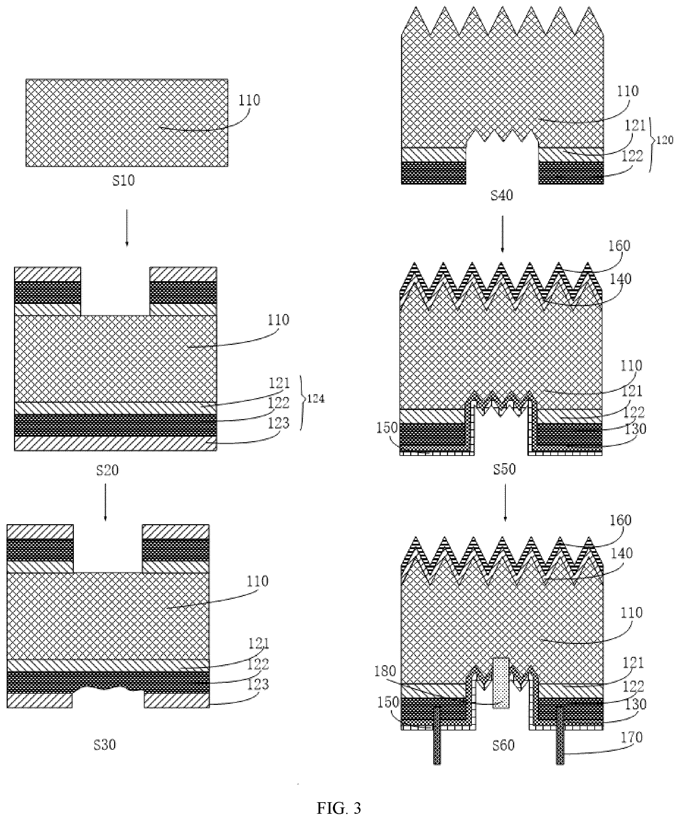

Referring to FIG. 3, the present disclosure provides a preparation method for a solar cell 10, including the following steps.

Step S10: providing a silicon wafer substrate 110 having a first surface and a second surface opposite to the first surface.

Further, the first surface described above refers to a non-light-facing surface of the cell, also known as a back surface, while the second surface described above refers to a light-receiving surface of the cell, also known as a front surface.

It should be understood that a damage removal treatment, a polishing treatment, or a cleaning treatment of the silicon wafer substrate 110 can be further included prior to the step S10.

Further, the damage removal treatment includes treating with a strong monobasic base at a concentration of 0.6 mol/L to 0.8 mol/L at a temperature of 50 °C to 70 °C.

Specifically, the temperature of the damage removal treatment can be, but is not limited to, 50 °C, 55 °C, 60 °C, 65 °C, or 70 °C.

Preferably, a solution for the damage removal treatment is a mixture solution of a sodium hydroxide solution with a mass percentage of 46% and water in a volume ratio of 4:96 to 6:94.

Yet further, the polishing treatment includes treating with a solution of a strong monobasic base at a concentration of 0.6 mol/L to 0.8 mol/L at a temperature of 65 °C to 85 °C to achieve a post-polishing reflectivity of 20% to 40%. Specifically, the post-polishing reflectivity can be, but is not limited to, 20%, 25%, 30%, 35%, or 40%. Preferably, the reflectivity of the polished silicon wafer substrate 110 is 30%.

In a specific example, the cleaning treatment includes washing with a mixture solution of hydrofluoric acid and hydrochloric acid and then with deionized water, and drying in an oven.

Step S20: forming a silicon-containing film 124 on the first surface of the silicon wafer substrate 110, the silicon-containing thin film 124 including a silicon oxide layer 121, a doped layer 122, and a mask layer 123 formed sequentially on the silicon wafer substrate 110.

In a specific example, in the step S20, the silicon-containing film 124 includes the silicon oxide layer 121, the doped layer 122, and the mask layer 123 sequentially stacked on the first surface of the silicon wafer substrate 110. The silicon oxide layer 121 has a thickness of 0.5 nm to 3 nm. The doped layer 122 has a thickness of 30 nm to 300 nm. The mask layer 123 has a thickness of 10 nm to 100 nm.

The silicon oxide layer 121 is deposited on the first surface by a method of plasma-enhanced chemical vapor deposition, low-pressure chemical vapor deposition, thermal oxidation, or chain oxidation. Then the doped layer 122 and the mask layer 123 are deposited on the silicon oxide layer 121 by a method of plasma-enhanced chemical vapor deposition, or low-pressure chemical vapor deposition.

Further, the method for forming the silicon oxide layer 121 is plasma-enhanced chemical vapor deposition, low-pressure chemical vapor deposition, thermal oxidation, or chain oxidation.

Preferably, the oxide layer is prepared by the low-pressure chemical vapor deposition at a temperature of 500°C to 650°C.

Yet further, the method for forming both the doped layer 122 and the mask layer 123 is the plasma-enhanced chemical vapor deposition or the low-pressure chemical vapor deposition.

It should be understood that the method for forming both the doped layer 122 and the mask layer 123 can be the plasma-enhanced chemical vapor deposition. Further, the method for forming both the doped layer 122 and the mask layer 123 can also be the low-pressure chemical vapor deposition.

Further, an embodiment of the method for forming the doped layer 122 by the low-pressure chemical vapor deposition includes: depositing a material of the doped layer 122 on the silicon oxide layer 121 at a temperature of 500 °C to 650 °C, converting amorphous silicon into polysilicon at a temperature of 800 °C to 950 °C, and then introducing oxygen in a certain amount into the furnace tube and growing the material of the mask layer 123 onto the outer side .

Another embodiment of the method for forming the doped layer 122 by the low-pressure chemical vapor deposition includes: depositing intrinsic amorphous silicon on the silicon oxide layer 121 at a temperature of 500 °C to 650 °C, diffusing a doping element into the intrinsic amorphous silicon, with gas introduced in the pre-deposition including both a dopant gas source and oxygen, and converting amorphous silicon into polysilicon at the above temperature.

Further, the plasma-enhanced chemical vapor deposition (PECVD) includes: forming the silicon oxide layer 121 by oxidization on the first surface of the silicon wafer substrate 110, introducing phosphane (PH₃) and silane (SiH₄) to deposit doped amorphous silicon (i.e., the doped layer 122), then introducing nitrous oxide (N₂O) and silane (SiH₄) to form silicon oxide as the mask layer 123 on the outermost side, and subsequently performing annealing treatment at a temperature of 800 °C to 950 °C for a time of 20 min to 50 min. The purpose of the annealing treatment is to promote the conversion of amorphous silicon to polysilicon and to facilitate the growth of crystalline grains, while making the silicon oxide mask layer 123 denser so as not to be corroded during the subsequent treatment with the alkali solution.

The conductive types of the doped layer 122 and the silicon wafer substrate 110 are each independently selected from N-type or P-type, and the conductive types of the doped layer 122 and the silicon wafer substrate 110 are different.

It should be understood that when the substrate 110 is of P-type, the doped layer 122 is of N-type, and the dopant is preferably phosphorus. Specifically, the material of the doped layer 122 can be, but is not limited to, phosphorus-doped polysilicon.

Further, the material of the mask layer 123 can be, but is not limited to, silicon oxide.

Step S30: patterning the silicon-containing film on the first surface by laser to form a patterned region 111 on the first surface of the silicon wafer substrate 110.

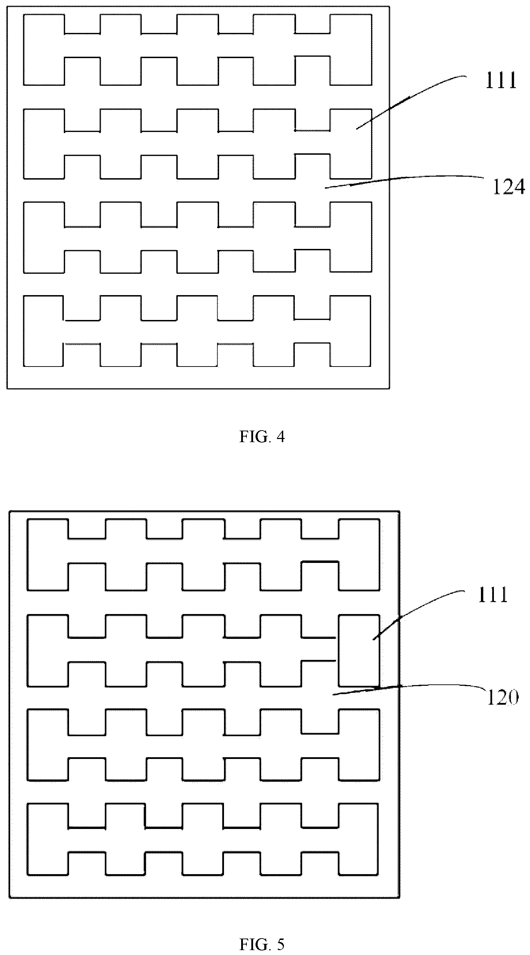

Specifically, a picosecond laser device is used to remove a partial region of the silicon-containing film 124 on the first surface of the silicon wafer substrate 110 utilizing an ultraviolet light at 355 nm or nano-laser at 532 nm to form a patterned region 111 with a width of 300 µm to 500 µm. With a part of the silicon-containing film in the patterned region 111 removed or damaged, the silicon-containing film can be more easily to be corroded by an alkali solution. FIG. 4 shows a top view of the patterned region 111 obtained after patterning the silicon-containing film 124.

Step S40: placing the silicon wafer substrate 110 having the silicon-containing film 124 and the patterned region 111 into an alkaline solution containing a strong monobasic base at a concentration of 0.3 mol/L to 2 mol/L for treatment, to obtain a pre-treated silicon wafer substrate 110, and subjecting the pre-treated silicon wafer substrate 110 to a texturing treatment.

A step of treating the material of the mask layer that is wrapped around the second surface of the substrate 110 with a hydrofluoric acid solution at a concentration of 4 mol/L to 6 mol/L is further included prior to the treatment with the alkaline solution.

The first surface of the substrate 110 is placed horizontally away from the hydrofluoric acid solution and covered with deionized water to prevent contact with the hydrofluoric acid solution, thus avoiding damage to the silicon oxide mask layer 123 on the first surface. The silicon oxide mask layer 123 in the non-laser region, i.e., in the region on the first surface other than the patterned region 111, can still protect the doped layer 122 in the non-laser region during the subsequent alkaline solution treatment and texturing liquid treatment. The second surface of the substrate 110 is placed in contact with the hydrofluoric acid solution to remove the silicon oxide mask layer that is wrapped around for a cleaning time of 60 s to 240 s.

It should be understood that the hydrofluoric acid solution described above is prepared by mixing hydrofluoric acid with a mass percentage of 49% with water in a volume ratio of (10 to 30) : (70 to 90), preferably in a volume ratio of 20 : 80.

In a specific example, the strong monobasic base is selected from a group consisting of potassium hydroxide, sodium hydroxide, and a combination thereof.

In a specific example, in the step S40, a time of the treatment with the alkaline solution is 10 s to 200 s.

It should be understood that the time of the treatment can be, but is not limited to, 10 s, 30 s, 50 s, 70 s, 90 s, 110 s, 130 s, 150 s, 170 s, 190 s, or 200 s.

In a specific example, a temperature of the treatment with the alkaline solution is 60°C to 80°C.

Further, the temperature of the treatment can be, but is not limited to, 60 °C, 65 °C, 70 °C, 75 °C, or 80 °C.

In the above-described preparation method for the solar cell 10, after the formation of the silicon-containing film 124 on the silicon wafer substrate 110 and the laser treatment to the silicon wafer substrate 110, the silicon wafer substrate having the silicon-containing film 124 and the patterned region 111 is placed into and treated with the alkaline solution containing the strong monobasic base at a concentration of 0.3 mol/L to 2 mol/L, and then subjected to the texturing treatment. The treatment with alkaline solution not only effectively removes the additional layer formed during the laser treatment but also removes the silicon-containing film wrapped around the second surface, so that in the subsequent texturing treatment, the surface of the substrate 110 can be effectively textured while the patterned region formed after the laser treatment can be effectively etched, ensuring a good appearance of the front surface of the cell and the performance of the cell.

In addition, the conventional preparation method for the silicon-containing film 124, such as plasma-enhanced chemical vapor deposition (PECVD) or low-pressure chemical vapor deposition (LPCVD), tends to form wrapping around the front surface of the silicon wafer substrate 110. By using hydrofluoric acid to remove the relatively thick silicon oxide mask layer 123 on the second surface of the substrate 110, in combination with the treatment with the alkaline solution, a synergistic effect can be achieved to remove all wrapping around the second surface (i.e., the light-receiving surface) of substrate 110, which is conductive to the subsequent texturing, especially the texturing of the second surface (i.e., the light-receiving surface) of substrate 110.

In a specific example, the alkaline solution further includes an additive. The additive can be, but is not limited to, Topband BP31.

Further, a volume ratio of the sodium hydroxide solution with a mass percentage of 46%, the additive, and water in the above-described alkaline solution is (15 to 25) : (1 to 5) : (400 to 480).

Preferably, the volume ratio of the sodium hydroxide solution with the mass percentage of 46%, the additive, and water in the above-described alkaline solution is 20 : (1 to 5) : (400 to 480).

In order to ensure that the doped layer 122 on the back surface will not be corroded and polished, the additive contains an organic group that can be adsorbed onto the mask layer 123 to form a barrier to prevent the mask layer 123 from reacting with the alkaline solution, and the additive contains a catalyst that can accelerate the reaction of the alkaline solution with silicon. By immersing the silicon wafer substrate 110 formed with the silicon-containing film 124 and subjected to the laser patterning treatment into the alkaline solution described above, and by coordinating the temperature and the time of the alkaline solution treatment and the concentration of the alkaline solution, not only the wrapping and the excess layer produced in the laser-treated region on the back surface of the substrate 110 can be effectively removed, but also the mask layer 123 that is not laser-treated on the doped layer 122 on the back surface can be protected, thereby avoiding the exposure of the doped layer 122 in the laser-untreated region.

The hydrofluoric acid treatment and the short time alkaline solution treatment can remove the silicon oxide mask layer 123, the doped layer 122, and the silicon oxide layer 121 that are wrapped around the front surface, ensuring the uniformity of the front surface of the substrate 110 before texturing and the uniformity of the subsequent texturing. The short time alkaline solution treatment also has a certain pre-etching effect on the laser region of the back surface to remove the additional material layer produced in the laser treatment. As a result, within the effective time of the subsequent texturing, the front surface can be textured, while the possible residual silicon containing film 124 on the back surface after the pre-etching can be etched to the first surface, or the first surface is directly etched as there is no residual silicon-containing film 124 on the back surface. After the treatment with the texturing liquid, a certain height difference, which is greater than 1 µm, is formed between the surfaces of the laser-treated region and the non-laser-treated region that are connected to each other (i.e., between the doped layer 122 and the substrate 110 that are connected to each other), thereby ensuring that the original doped layer 122 in the laser-treated region is completely removed to avoid the failure or inefficiency of the prepared cell.

In a specific example, the pre-treated silicon wafer substrate 110 is subjected to the following texturing treatment: placing the silicon wafer substrate 110 having the silicon-containing film and the patterned region 111 into a texturing liquid containing a strong monobasic base at a concentration of 0.15 mol/L to 0.35 mol/L for the texturing treatment for a time of 400 s to 600 s to prepare the silicon wafer substrate 110 with a textured surface.

It should be understood that the purpose of texturing is to form a pyramid textured surface on the second surface (i.e., the light-receiving surface) of the substrate 110. When the texturing of the second surface (i.e., the light-receiving surface) of the substrate 110 is completed, the patterned region 111 is formed with an etching depth of 1 µm to 6 µm. The patterned region 111 of the first surface is also of a textured surface due to the etching effect of the alkaline texturing liquid. The non-patterned region of the first surface of the substrate 110 will not be corroded by the alkaline solution and the texturing liquid due to the protection of the intact silicon oxide mask layer 123.

Further, the above-described texturing liquid can further include an additive which can be, but is not limited to, Scenergy ST10.

A step including, but not limited to, water washing, alkali washing, water washing, acid washing, water washing, and oven-drying can be further included after the texturing.

The alkali washing includes washing with a sodium hydroxide aqueous solution with a mass percentage of 0.1% to 0.2%. Further, the acid washing includes washing with an acid solution containing hydrofluoric acid to remove the outermost silicon oxide mask layer 123 on the non-patterned region outside the patterned region 111 on the first surface of the substrate 110.

In a specific example, after preparing the silicon wafer substrate 110 with the textured surface, the following step S50 is included: sequentially forming a first passivation film 130 and a first anti-reflection film 150 on the composite film 120 and the first surface of the silicon wafer substrate 110 having the textured surface.

It should be understood that the first passivation film 130 and the first anti-reflection film 150 are sequentially formed on the doped layer 122, the silicon oxide layer 121, and the first surface of the silicon wafer substrate 110 having the textured surface.

Further, a second passivation film 140 and a second anti-reflection film 160 are sequentially formed on the second surface of the wafer substrate 110 having the textured surface.

It should be understood that the method for forming the first passivation film 130 or the second passivation film 140 described above can be, but is not limited to, an atomic layer deposition method. Further, a material of the first passivation film 130 or the second passivation film 140 can be, but is not limited to, aluminum oxide.

In a specific example, the first passivation film 130 has a thickness of 2 nm to 25 nm. The second passivation film 140 has a thickness of 2 nm to 25 nm.

Further, the method for forming the first anti-reflection film 150 or the second anti-reflection film 160 described above can be, but is not limited to, plasma-enhanced chemical vapor deposition. Further, a material of the first anti-reflection film 150 or the second anti-reflection film 160 can be, but is not limited to, silicon oxide, silicon nitride, or a combination thereof.

Further, the first anti-reflection film 150 has a thickness of 50 nm to 150 nm. The second anti-reflection film 160 has a thickness of 60 nm to 150 nm.

It should be understood that a material of the first anti-reflection film 150 or the second anti-reflection film 160 contains silicon oxide material and silicon nitride material which are in a two-layer material stack.

In a specific example, the following step S60 is further included: patterning the patterned region on the first surface with laser to form patterned holes, and preparing a first electrode 170 and a second electrode 180 by screen printing.

A burn-through electrode slurry is coated to a region other than the patterned region 111 on the first surface, the first passivation film 130 and the first anti-reflection film 150 at the region coated with the burn-through electrode slurry are removed, and the burn-through electrode slurry is injected until the burn-through electrode slurry is in contact with the silicon-containing film 124 to obtain the first electrode 170.

The patterned region 111 on the first surface is patterned to form holes by laser to remove the first passivation film 130 and the first anti-reflection film 150 at the holes to form a second electrode contact region. An electrode slurry is injected into the second electrode contact region to obtain the second electrode 180.

The patterned region 111 on the first surface is patterned to form holes with a width of 30µm to 50µm by laser to remove the first passivation film 130 and the first anti-reflection film 150 at the holes to form a first electrode 170 contact region. The hole regions are distributed in a dashed line or in dots. FIG. 5 shows a top view of the patterned region 111 with holes.

It should be understood that the above-described method for forming the first electrode 170 or the second electrode 180 can be, but is not limited to, screen printing. The first electrode 170 in contact with the doped layer 122 is formed without the hole patterning. The first electrode preferably uses a burn-through electrode slurry at a high temperature which can burn through the first passivation film 130 and the first anti-reflection film 150 to form contact with the doped layer 122. Whereas, a non-burn-through electrode slurry is used to form local contact with the substrate 110, that is, the non-burn-through electrode slurry is in contact with the substrate 110 at the hole region formed by laser.

Specifically, the first electrode 170 and the second electrode 180 are metal electrodes. Materials of the first electrode 170 and the second electrode 180 can be each independently selected from, but are not limited to, one of aluminum and silver.

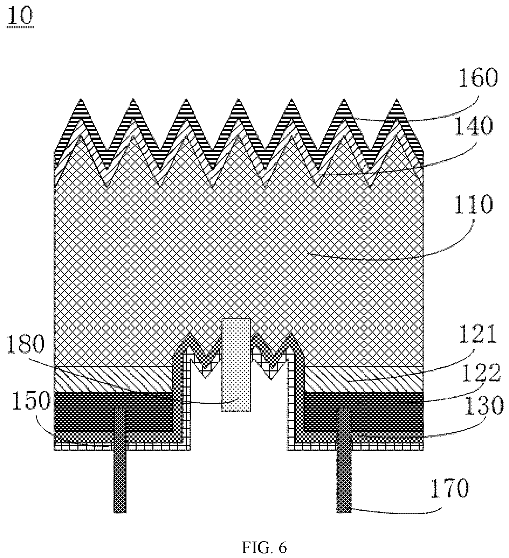

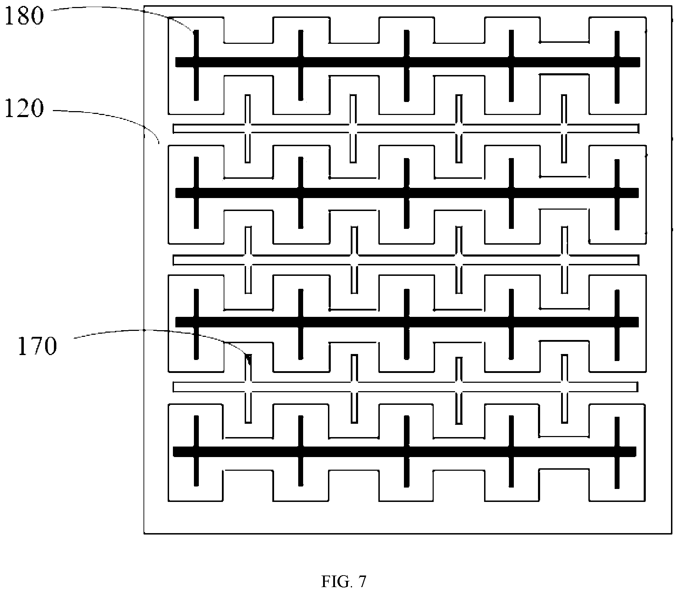

Further, as shown in FIG. 6, the present disclosure further provides a solar cell 10 prepared by the above-described preparation method for the solar cell 10. FIG. 7 shows a top view of the solar cell 10.

The above-described solar cell 10 obtained after the preparation process is preferably a back-contact solar cell.

The present disclosure further provides a photovoltaic system including a solar cell assembly and an auxiliary device. The solar cell assembly includes the above-described solar cell 10.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A preparation method for a solar cell, comprising:
S10: providing a silicon wafer substrate having a first surface and a second surface opposite to the first surface;
S20: forming a silicon-containing film on the first surface of the silicon wafer substrate, the silicon-containing film comprising a silicon oxide layer, a doped layer, and a mask layer formed sequentially on the first surface of the silicon wafer substrate;
S30: patterning the silicon-containing film on the first surface by laser to form a patterned region; and
S40: placing the silicon wafer substrate having the silicon-containing film and the patterned region into an alkaline solution containing a strong monobasic base for pre-treatment, to obtain a pre-treated silicon wafer substrate, and placing the pre-treated silicon wafer substrate into a texturing liquid containing a strong monobasic base for texturing treatment, wherein a concentration of the strong monobasic base in the alkaline solution used in the pre-treatment is greater than a concentration of the strong monobasic base in the texturing liquid used in the texturing treatment.

2. The preparation method for the solar cell of claim 1, wherein the strong monobasic base is selected from a group consisting of potassium hydroxide, sodium hydroxide, and a combination thereof.

3. The preparation method for the solar cell of claim 1 or 2, wherein in the step S40, a concentration of the strong monobasic base in the alkaline solution is in a range from 0.3 mol/L to 2 mol/L.

4. The preparation method for the solar cell of any one of claims 1 to 3, wherein in the step S40, a time of the treatment with the alkaline solution is in a range from 10 s to 200 s.

5. The preparation method for the solar cell of any one of claims 1 to 4, wherein in the step S40, a temperature of the treatment with the alkaline solution is in a range from 60 °C to 80 °C.

6. The preparation method for the solar cell of any one of claims 1 to 5, wherein in the step S20, the silicon oxide layer is deposited on the first surface by a method of plasma-enhanced chemical vapor deposition, low-pressure chemical vapor deposition, thermal oxidation, or chain oxidation, and then the doped layer and the mask layer are deposited on the silicon oxide layer by a method of plasma-enhanced chemical vapor deposition or low-pressure chemical vapor deposition.

7. The preparation method for the solar cell of any one of claims 1 to 6, further comprising a step of treating the silicon-containing film wrapped around the second surface of the substrate with a hydrofluoric acid at a concentration of 4 mol/L to 6 mol/L after the step S30 and before the step S40.

8. The preparation method for the solar cell of any one of claims 1 to 7, wherein in the step S40, the texturing treatment comprises: placing the pre-treated silicon wafer substrate into the texturing liquid containing the strong monobasic base at a concentration of 0.15 mol/L to 0.35 mol/L for the texturing treatment to prepare the silicon wafer substrate with a textured surface.

9. The preparation method for the solar cell of any one of claims 1 to 8, after preparing the silicon wafer substrate with the textured surface, further comprising:
S50: sequentially forming a first passivation film and a first anti-reflection film on the first surface of the silicon wafer substrate having the textured surface.

10. The preparation method for the solar cell of claim 8 or 9, after preparing the silicon wafer substrate with the textured surface, further comprising:
S50: sequentially forming a second passivation film and a second anti-reflection film on the second surface of the silicon wafer substrate having the textured surface.

11. The preparation method for the solar cell of claim 9 or 10, after the step S50, further comprising:
S60: patterning the patterned region on the first surface to form holes by laser, and preparing a first electrode and a second electrode by screen printing.

12. A solar cell, prepared by the preparation method for the solar cell of any one of claims 1 to 11.

13. A photovoltaic system, comprising a solar cell assembly and an auxiliary device, wherein the solar cell assembly comprises the solar cell of claim 12.
